# EUROPEAN PATENT APPLICATION

(11) **EP 2 333 896 A1**
(43) Date of publication of application: **15.06.2011**
(21) Application number: 09809516.9
(22) Date of filing: 24.08.2009
(51) Int. Cl.: H01M 14/00, H01L 31/04

(54) **DYE-SENSITIZED SOLAR CELL AND METHOD FOR MANUFACTURING SAME**

(30) Priority: 29.08.2008 JP 2008221170
(71) Applicant: Nippon Steel Chemical Co., Ltd., Chiyoda-ku Tokyo 101-0021 (JP); National University Corporation Kyushu Institute Of Technology, Tobata-ku Kitakyushu-shi Fukuoka 804-8550 (JP)
(72) Inventor: YAMAGUCHI, Yoshihiro, Kitakyusyu-shi Fukuoka 804-8503 (JP); HAYASE, Shuzi, Kitakyushu-shi Fukuoka 804-8550 (JP)
(74) Representative: Giles, Ashley Simon
(86) International application number: PCT/JP2009/004047
(87) International publication number: WO 2010/023860

(57) **Abstract**

To provide a dye-sensitized solar cell capable of significantly improving power extraction efficiency, and a manufacturing method of the dye-sensitized solar cell. The dye-sensitized solar cell includes a substrate, a porous semiconductor layer adsorbing a dye, a conductive metal layer, and a conductive substrate. The conductive metal layer 16 is a current collector provided on the side of the porous semiconductor layer, the side being opposite to the side on which the substrate is arranged. The conductive metal layer 16 is configured by a conductive metal section 17 made of a mesh member, and a coating section 19 formed on the conductive metal section 17. The coating section 19 is configured by an inner layer 19a and an outer layer 19b, and has a graded composition structure in which the degree of oxidization of the coating section is increased from the side of the conductive metal section 17 toward the side of the porous semiconductor layer 14. Thereby, the coating section 19 has a graded composition structure in which the thermal expansion coefficient of the coating section is reduced from the side of the conductive metal section 17 toward the side of the porous semiconductor layer 14.

## Description

### Technical Field

The present invention relates to a dye-sensitized solar cell and a manufacturing method of the dye-sensitized solar cell.

### Background Art

A dye-sensitized solar cell is referred to as a wet-type solar cell or a Graetzel cell, and is featured by having an electrochemical cell structure that is composed typically of an iodine solution without using a silicon semiconductor. Specifically, the dye-sensitized solar cell has a simple structure in which an iodine solution, or the like, is arranged, as an electrolytic solution, between a porous semiconductor layer, such as a titania layer, formed by baking titanium dioxide power, or the like, onto a transparent conductive glass plate (a transparent substrate with a transparent conducting film laminated thereon) and then by making a dye adsorbed in the baked powder, and a counter electrode made of a transparent conductive glass plate (a conductive substrate). In the dye-sensitized solar cell, sunlight introduced into the solar cell from the side of the transparent conductive glass plate is absorbed into the dye, so that electrons are generated.

The dye-sensitized solar cell has been attracting attention as a low-cost solar cell because the solar cell uses inexpensive materials and does not need large-scale equipment for manufacturing the solar cell.

In the dye-sensitized solar cell, it has been required to further improve the conversion efficiency of sunlight, and hence the methods to improve the conversion efficiency have been studied from various viewpoints.

As one of the methods, a method, such as a method for eliminating the transparent conductive film, which is normally formed on the transparent substrate provided on the light incident side, has been studied in order to improve the conductivity of the electrode and to thereby increase the power extraction efficiency. The improvement in the electrical conductivity of the electrode has a particularly high significance when the size of the solar cell is increased.

As a technique to improve the electrical conductivity of the electrode, a photoelectric conversion device is disclosed, which is provided with a structure having a laminated section that includes, for example, a semiconductor fine particle layer, a metal net, a charge transport layer, and a counter electrode in this order on a glass substrate (see Patent Literatures 1 and 2).

Further, for example, an electrode for a dye-sensitized solar cell is disclosed, in which the resistance of the electrode is reduced by providing, on a substrate, a transparent conductive film and a mesh-like conductive body made of a metal or an alley having resistance lower than the resistance of the transparent conductive film, in which a passivation film is further formed on the surface of the mesh-like conductive body in order to prevent the increase in the resistance value of the mesh-like conductive body due to the oxidization of the mesh-like conductive body, and in which a film, such as a semiconductor film, is further formed on the passivation film (see Patent Literature 3).

Further, for example, a dye-sensitized solar cell is disclosed, which has a SUS electrode provided as a current collecting electrode on a transparent substrate, and in which an SiOₓ film widely used as an insulator is formed on the SUS electrode by sputtering, and further an ITO is formed on the SiOₓ film by sputtering (see Non Patent Literature 1). It is reported that the sunlight conversion efficiency of this solar cell is 4.2%.

Note that various techniques are disclosed, in which the counter electrode is formed by a conductive transparent substrate, and in which light is introduced into the dye-sensitized solar cell from the side of the counter electrode (see, for example, Patent Literature 4).

### Citation List

### Patent Literature

Patent Literature 1: Japanese Patent Laid-Open No. 2001-283941
Patent Literature 2: Japanese Patent Laid-Open No. 2007-73505
Patent Literature 3: Japanese Patent Laid-Open No. 2005-197176
Patent Literature 4: Japanese Patent No. 2664194

### Non Patent Literature

Non Patent Literature 1: Kang-Jin Kim and et al., A4.2% efficient flexible dye-sensitized TiO2 solar cells using stainless steel substrate, Solar Energy Materials & Solar Cells 90 (2006) 574-581

### Summary of Invention

### Technical Problem

However, any of the above-described conventional techniques needs to be further improved in order to further increase the power extraction efficiency.

The present invention has been made in view of the above-described circumstances. An object of the present invention is to provide a dye-sensitized solar cell capable of further improving the power extraction efficiency, and a manufacturing method of the dye-sensitized solar cell.

### Solution to Problem

A dye-sensitized solar cell according to the present invention, which is configured by including a substrate, a conductive substrate serving as a cathode electrode, a porous semiconductor layer adsorbing a dye and arranged between the substrate and the conductive substrate so as to be close to or in contact with the substrate, and a conductive metal layer arranged in contact with the porous semiconductor layer so as to serve as an anode electrode, and which is configured such that at least one of the substrate and the conductive substrate is a transparent substrate, and such that an electrolyte is enclosed between the substrate and the conductive substrate, is featured
in that the conductive metal layer is configured by
a conductive metal section and a coating section formed at least on the side of the conductive metal section, the side being in contact with the porous semiconductor layer, and
in that the coating section has a graded composition structure in which the thermal expansion coefficient of the coating section is reduced from the side of the conductive metal section toward the side of the porous semiconductor layer.

Further preferably, the dye-sensitized solar cell according to the present invention is featured in that the coating section has a graded composition structure in which the degree of oxidation of the coating section is increased from the side of the conductive metal section toward the side of the porous semiconductor layer.

Further preferably, the dye-sensitized solar cell according to the present invention is featured in that the coating section is formed of an oxide which is made of one or more kinds of corrosion-resistant metal materials selected from a group of Ti, W, Ni, Pt and Au.

Further preferably, the dye-sensitized solar cell according to the present invention is featured in that the conductive metal layer is a current collector arranged on the side of the porous semiconductor layer, the side being opposite to the side on which the substrate is provided, in that the conductive metal section has numerous holes formed therein for allowing the electrolyte to freely flow through the porous semiconductor layer and is electrically connected to an external electrode, and in that the substrate is a transparent substrate.

Further preferably, the dye-sensitized solar cell according to the present invention is featured in that the conductive metal section of the conductive metal layer is formed of a mesh member.

Further preferably, the dye-sensitized solar cell according to the present invention is featured in that the conductive metal layer is a current collector provided on the surface of the substrate, in that the conductive metal section is provided on the side in contact with the substrate, and the coating section is provided to cover the conductive metal section, and in that the conductive substrate is a transparent substrate.

Further, a manufacturing method of the dye-sensitized solar cell, according to the present invention, is featured in that, in the process of forming the coating section on the conductive metal section formed beforehand, the graded composition structure is formed by forming a film of a raw material metal of a conductive metal coating by a thin-film technique while introducing a small amount of a compound containing one or more kinds of elements selected from a group of O, N, S, P, B and C.

Further, a manufacturing method of the dye-sensitized solar cell, according to the present invention, is featured in that, in the process of forming the coating section on the conductive metal section formed beforehand, the graded composition structure is formed by including a stage of forming a sputtered layer on the conductive metal section by a sputtering method, and a stage of forming a vapor deposition layer on the surface of the sputtered layer by a vacuum vapor deposition method.

Further preferably, the manufacturing method of the dye-sensitized solar cell according to the present invention is featured in that the vacuum vapor deposition method is one of an arc plasma vapor deposition method and a vacuum arc vapor deposition method.

Further preferably, the dye-sensitized solar cell according to the present invention is featured in that the coating section has a laminated structure which is formed of two or more kinds of different materials so that the thermal expansion coefficient of the coating section is reduced from the side of the conductive metal section toward the porous semiconductor layer.

### Advantageous Effects of Invention

The dye-sensitized solar cell according to the present invention is configured such that the conductive metal layer arranged in contact with the porous semiconductor layer so as to serve as the anode electrode is configured by the conductive metal section and the coating section provided at least on the side of the conductive metal section, the side being in contact with the porous semiconductor layer, and such that the coating section has the graded composition structure in which the thermal expansion coefficient is reduced from the side of the conductive metal section toward the side of the porous semiconductor layer. Thereby, the dye-sensitized solar cell according to the present invention is capable of obtaining high power extraction efficiency.

Further, the manufacturing method of the dye-sensitized solar cell according to the present invention forms, in the process of forming the coating section on the conductive metal section formed beforehand, the graded composition structure by forming a film by a thin-film technique while introducing a small amount of a compound containing one or more kinds of elements selected from a group of 0, N, S, P, B and C. Thereby, it is possible to suitably obtain the dye-sensitized solar cell according to the present invention.

### Brief Description of Drawings

[Figure 1] Figure 1 is a schematic diagram showing a cross-sectional structure of a dye-sensitized solar cell according to a first example of the present embodiment.
[Figure 2] Figure 2 is a diagram for explaining a conductive metal layer configured by a conductive metal section formed by a mesh member, and a coating section formed on the conductive metal section.
[Figure 3] Figure 3 is a diagram for explaining a conductive metal layer configured by a sheet-like conductive metal section subjected to perforation processing beforehand, and a coating section formed on the conductive metal section.
[Figure 4] Figure 4 is a schematic diagram showing a cross-sectional structure of a dye-sensitized solar cell according to a second example of the present embodiment.
[Figure 5] Figure 5 is a diagram for explaining an example of a manufacturing method of the dye-sensitized solar cell according to the present embodiment.
[Figure 6] Figure 6 is a diagram for explaining another example of the manufacturing method of the dye-sensitized solar cell according to the present embodiment.
[Figure 7] Figure 7 is a diagram for explaining the manufacturing method of the dye-sensitized solar cell.
[Figure 8] Figure 8 is a diagram showing results of SEM surface observation of layers used as the coating section, in which Figure 8(a) shows a result of SEM surface observation of the layer formed by a conventional coating method, in which Figure 8(b) shows a result of SEM surface observation of the layer formed by a sputtering method according to the present embodiment, and in which
Figure 8(c) shows a results of SEM surface observation of the layer formed by an arc plasma vapor deposition method according to the present embodiment.

### Description of Embodiments

In the following, a preferred embodiment of a dye-sensitized solar cell according to the present invention and a manufacturing method of the dye-sensitized solar cell will be described with reference to the accompanying drawings.

The present inventors have made various examinations on the cause of the low power extraction efficiency of the conventional dye-sensitized solar cell described above.

In the conventional technique, when a titania paste is applied to a low resistance conductive metal coated with a protective film, or the like, for prevention of oxidation corrosion in place of a transparent conductive film and is then sintered, a stainless material having a thermal expansion coefficient (linear expansion coefficient) of, for example, about 16×10⁻⁶/°C is used as the conductive metal. The present inventors came to the realization that at this time, the difference in thermal expansion coefficient between the conductive metal and the titania sintered layer having a thermal expansion coefficient of about 5×10⁻⁶/°C is large, and thereby a difference in expansion and contraction rates between the conductive metal and the titania sintered layer is caused during the heating and cooling process at the time of sintering the titania, so as to generate a shearing force between the conductive metal and the titania sintered layer, and that this shearing force may cause partial exfoliation in the protective film, and the like, so as to prevent the photoelectric conversion efficiency from being fully obtained.

Further, in order to improve the above described Problem, the present inventors came up with an idea that, in the member corresponding to the protective film, and the like, the portion of the member, which portion is on the side close to the conductive metal, is formed of a material having a thermal expansion coefficient close to that of the conductive metal, and the portion of the member, which portion is on the side close to the titania sintered layer, is formed of a material having a thermal expansion coefficient close to that of the titania sintered layer.

That is, the basic principle of the dye-sensitized solar cell according to the present embodiment is as follows.

The dye-sensitized solar cell includes: a substrate; a conductive substrate serving as a cathode electrode; a porous semiconductor layer adsorbing a dye and arranged between the substrate and the conductive substrate so as to be close to or in contact with the substrate; and a conductive metal layer arranged in contact with the porous semiconductor layer so as to serve as an anode electrode. At least one of the substrate and the conductive substrate is a transparent substrate, and an electrolyte is enclosed in the dye-sensitized solar cell.

The conductive metal layer is configured by a conductive metal section and a coating section formed at least on the side of the conductive metal section, the side being in contact with the porous semiconductor layer. The coating section has a graded composition structure in which the thermal expansion coefficient of the coating section is reduced from the side of the conductive metal section toward the side of the porous semiconductor layer.

With the above described configuration, even when the shearing force is generated between the conductive metal section and the porous semiconductor layer (titania sintered layer) due to the difference in expansion and contraction rates between the conductive metal section and the titania sintered layer, the stress applied to the coating section is reduced, so as to thereby reduce the phenomenon that a crack is caused in the coating section and further the coating section is exfoliated from the conductive metal section. Thereby, the function of the coating section is maintained without being impaired, and hence high power extraction efficiency (conversion efficiency) can be obtained.

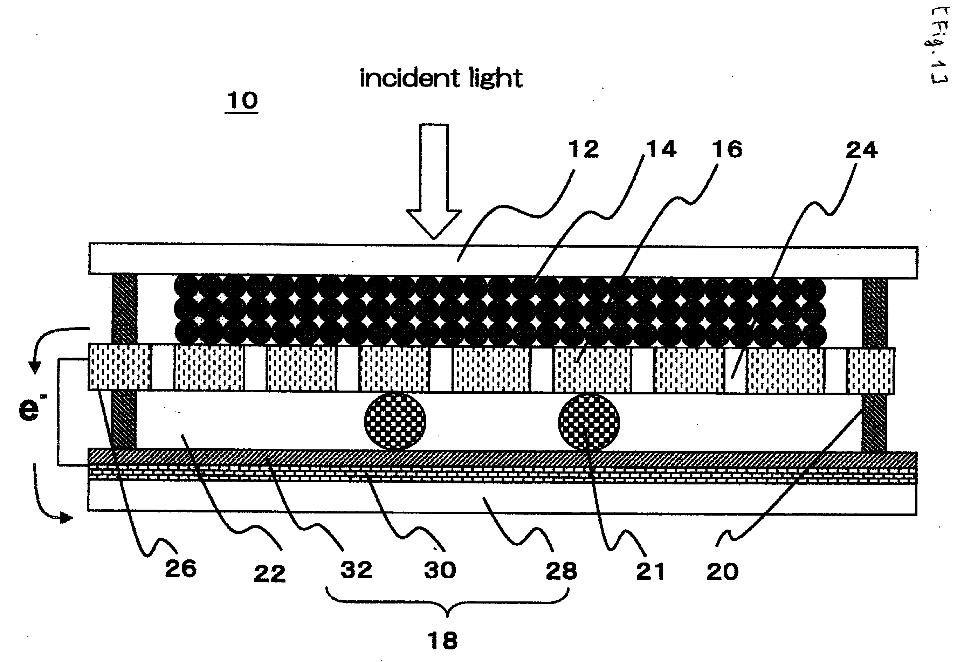

First, a dye-sensitized solar cell according to a first example of the present embodiment will be described with reference to a schematic diagram shown in Figure 1.

A dye-sensitized solar cell 10 according to the first example of the present embodiment includes: a substrate 12; a porous semiconductor layer 14 adsorbing a dye and arranged on the substrate 12 (provided on the lower surface of the substrate 12 in Figure 1, and hereinafter similarly provided); a conductive metal layer 16 arranged on the surface of the porous semiconductor layer 14 on the side opposite to the transparent substrate 12; and a conductive substrate 18 provided so as to face the substrate 12.

An internal spacer 21 (supporting body) is provided between the conductive metal layer 16 and the conductive substrate 18. An electrolyte (electrolytic solution) 22 is filled in the space of the dye-sensitized solar cell 10, which space is sealed with spacers 20.

The substrate 12 is a transparent substrate, and hence incident light is introduced into the cell of the dye-sensitized solar cell 10 from side of the substrate 12.

The porous semiconductor layer 14 may be arranged in contact with the substrate 12 as shown in Figure 1, or may also be arranged close to the substrate 12.

The conductive metal layer 16 is electrically connected to an external electrode 26. Note that the external electrode 26 may be provided at a suitable position independently of the substrate 12.

The conductive substrate 18 is configured by a substrate 28, a transparent conductive film 30 formed on the substrate 28, and a catalyst film (catalyst layer) 32 formed on the transparent conductive film 30. However, the configuration of the conductive substrate 18 is not limited to this, and a suitable configuration usually adopted may also be used for the conductive substrate 18.

The internal spacer 21 is provided in order to more surely provide electrical insulation between the conductive metal layer 16 and the conductive substrate 18. As the internal spacer 21, it is possible to use, for example, a spherical object formed of a zirconia material and having a diameter of about 20 µm, a non-woven fabric made of resin or glass insoluble in the electrolytic solution, or the like. However, the internal spacer 21 does not necessarily need to be provided as long as the conductive metal layer 16 and the conductive substrate 18 can be surely separated from each other by the spacer 20.

Each of the substrate 12 and the substrate 28 may be, for example, a glass plate or a plastic plate. When a plastic plate is used, it is possible to list, as the material of the plastic plate, for example, PET, PEN, polyimide, cured acrylic resin, cured epoxy resin, cured silicone resin, various engineering plastics, a cyclic polymer obtained by metathesis polymerization, and the like.

The transparent conductive film 30 may be, for example, an ITC (tin-doped indium oxide film), an FTO (fluorine-doped tin oxide film), an SnO₂ film, or the like.

As the catalyst film 32, it is possible to use a platinum film, a film made of high conductivity carbon, and the like.

The porous semiconductor layer 14 is sintered at a temperature of 300°C or more, and is more preferably sintered at a temperature of 450°C or more. On the other hand, although the upper limit of the sintering temperature is not particularly set, the sintering temperature is set to a temperature sufficiently lower than the melting point of the material of the porous semiconductor layer 14, and more preferably is set to a temperature of 550°C or less.

The thickness of the porous semiconductor layer 14 is not particularly limited, but is preferably set to a thickness of 14 µm or more.

The dye adsorbed in the porous semiconductor layer 14 is a dye which is adsorbed in the semiconductor material forming the porous semiconductor layer 14, and has an absorption band in the wavelength range of 400 nm to 1000 nm. As such a dye, it is possible to list a metal complex, such as ruthenium dye and phthalocyanine dye, having a COOH group, and an organic dye, such as cyanine dye. A plurality of dyes having different light absorption bands may be mixed with each other so as to be adsorbed in the porous semiconductor layer 14, or a plurality of dyes having different light absorption bands may also be adsorbed in layers in the porous semiconductor layer 14.

The electrolyte 22 contains iodine, lithium ions, an ionic liquid, t-butyl pyridine, and the like. For example, as for iodine, it is possible to use an oxidation-reduction agent composed of a combination of iodide ions and iodine. The oxidation-reduction agent contains a suitable solution which can dissolve the oxidation-reduction agent.

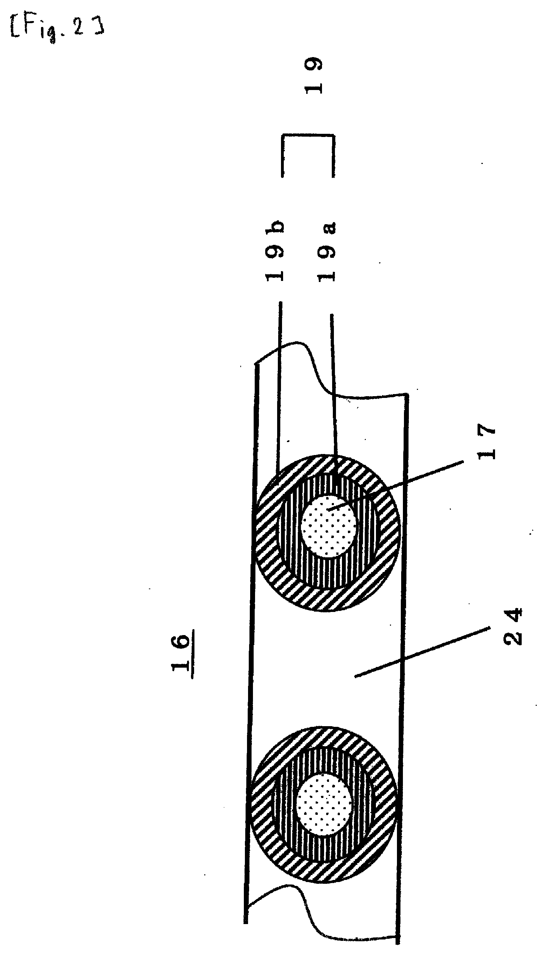

The conductive metal layer 16 is a current collector which is arranged on the side of the porous semiconductor layer 14, the side being opposite to the side on which the substrate 12 is provided. As shown in Figure 2, the conductive metal layer 16 is configured by a conductive metal section 17 and a coating section 19 formed on the conductive metal section 17. The coating section 19 is configured by an inner layer 19a and an outer layer 19b. In the conductive metal layer 16, numerous holes 24 are formed in the conductive metal section 17 so as to allow the electrolyte 22 to freely flow through the porous semiconductor layer 14.

The conductive metal section 17 shown in Figure 2 is a mesh member. The coating section 19 is formed by the film forming method described below so as to cover the whole surface of the conductive metal section 17, but is not limited to this. In the case where the corrosion resistance of the conductive metal section 17 does not need to be increased so much, the coating section 19 may be formed, as required, at least on the side of the conductive metal section 17, the side is in contact with the porous semiconductor layer 14. This is also the same as in another embodiment as will be described below.

The coating section 19 has a graded composition structure in which the degree of oxidation of the coating section is increased from the side of the conductive metal section 17 toward the side of the porous semiconductor layer 14. In the graded composition structure, the composition may be continuously changed, or may also be changed in stages (stepwise). That is, the coasting section 19 may be formed in a single-layer structure so that the degree of oxidation is gradually changed from the inner side to the outer side at the time of film formation. Further, the coating section 19 may also be formed in a multi-layer structure of different material layers, in which structure two or more kinds of materials having different degrees of oxidation are used, in which structure the inner layer on the side of the conductive metal section 17 is formed of the material having the lower degree of oxidation, and in which structure the outer layer on the side of the porous semiconductor layer 14 is formed of the material having the higher degree of oxidation.

In the case of the coating section 19 shown in Figure 2, the degree of oxidation of the outer layer 19b is higher than the degree of oxidation of the inner layer 19a.

The thickness of the conductive metal section 17 is not particularly limited, and can be set to, for example, about several tens nm to about several tens µm. However, the thickness of about several µm to about 10 µm of the conductive metal section 17 is suitable and sufficient from the viewpoint of obtaining low electric resistance (resistor).

The thickness of the coating section 19 is not particularly limited and can be set to about several hundreds nm. However, the thickness of at least 20 nm cr more of the coating section 19 is more preferred from the viewpoint of preventing reverse electron transfer from the conductive metal layer 16 to the electrolyte 22 and from the viewpoint of reducing the difference in the thermal expansion coefficient between the coating section 19 and the conductive metal section 17.

As the material of the conductive metal section 17, a suitable metal can be selected and used as long as it has suitable conductive property. For example, a metal, such as Ti, Pt, Au and Ag, an alloy of these metals, and a metal compound, such as a metal oxide, of these metals can be used. Further, a metal, such as stainless steel, iron, copper, aluminum, tin, can also be used. Among these materials, it is preferred to use stainless steel from a viewpoint of reducing material cost and from the viewpoint of obtaining high conductive property.

As the material of the coating section 19, it is preferred to use a corrosion-resistant metal material, and it is more preferred to use an oxide of one or more kinds of corrosion-resistant metal materials selected from a group of Ti, W, Ni, Pt, and Au.

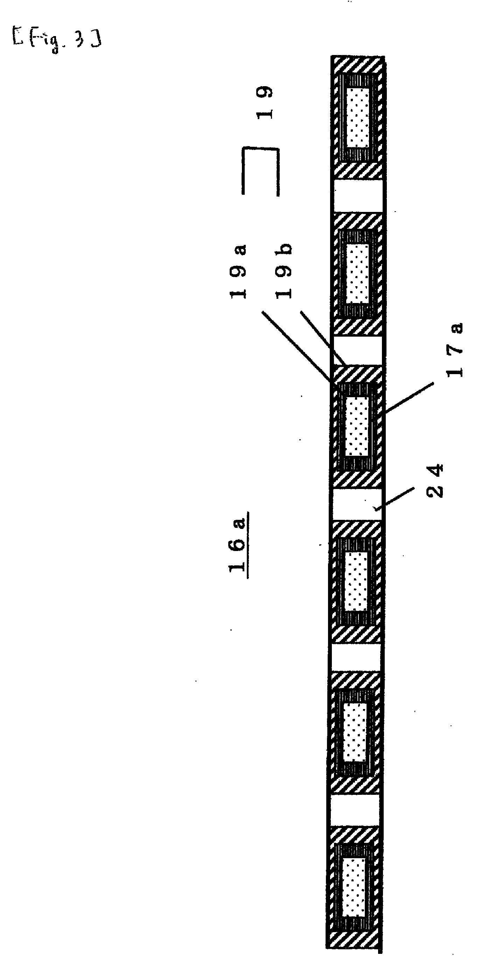

In place of the conductive metal layer 16 shown in Figure 2, a conductive metal layer 16a having a conductive metal section 17a as shown in Figure 3 may also be used.

The conductive metal layer 16a is formed, for example, by using the sheet-like conductive metal section 17a subjected to perforation processing beforehand, and then by covering the sheet-like conductive metal section 17a with the coating section 19. In this case, holes can be formed in a desired dimension, shape, and arrangement.

In the dye-sensitized solar cell 10 according to the first example of the present embodiment, configured as described above, the coating section 19 has the graded composition structure in which the degree of oxidation of the coating section 19 is increased from the side of the conductive metal section 17 or 17a toward the side of the porous semiconductor layer 14, and thereby the coating section 19 has the graded composition structure in which the thermal expansion coefficient of the coating section 19 is reduced from the side of the conductive metal section 17 or 17a toward the side of the porous semiconductor layer 14. That is, the inner layer 19a of the coating section 19 has a high thermal expansion coefficient close to that of the conductive metal section 17, while the outer layer 19b of the coating section 19 has a low thermal expansion coefficient close to that of the porous semiconductor layer 14.

Note that the graded composition structure of the coating section 19, in which structure the thermal expansion coefficient of the coating section 19 is reduced from the side of the conductive metal section 17 toward the side of the porous semiconductor layer 14, can also be obtained, for example, in such a manner that two or more kinds of materials having different thermal expansion coefficients are used, that the portion of the coating section on the side of the conductive metal section 17 is formed of the material having the larger thermal expansion coefficient, and that the portion of the coating section on the side of the porous semiconductor layer 14 is formed of the material having the smaller thermal expansion coefficient.

As a result, in the dye-sensitized solar cell 10, since the phenomenon that, due to the severe temperature change at the time of manufacture, a crack is generated in the coating section and further the coating section is exfoliated from the conductive metal section, and the phenomenon that the conductive metal coating section is separated from the porous semiconductor layer are reduced, the function of the coating section is maintained without being impaired, and a desirable close contact property between the porous semiconductor layer and the conductive metal layer can be held. As a result, it is possible to obtain high power extraction efficiency in the dye-sensitized solar cell 10.

Further, a process, in which the porous semiconductor layer 14 is formed by sintering the titania paste applied on the substrate 12, is usually adopted. Thus, it is necessary to use a glass substrate as the substrate 12 in order to enable the substrate 12 to withstand the high temperature of, for example, over 450°C. On the other hand, in the dye-sensitized solar cell 10, the conductive metal layer 16 or 16a, on which the porous semiconductor layer 14 is formed, can be joined with the substrate 12 at the time of cell assembly, and, thereby, a flexible plastic material can be used as the substrate 12.

Further, in the dye-sensitized solar cell 10, electrons are easily moved in the inside of the porous semiconductor layer 14 via the conductive metal layer 16, and further the reverse electron transfer is hardly caused in the interface between the conductive metal layer 16 and the electrolyte 22.

Further, in the dye-sensitized solar cell 10, a glass substrate with a transparent conductive film is not used, and hence an inexpensive substrate 12 can be used.

Further, in the dye-sensitized solar cell 10, a more excellent close contact property between the coating section and the porous semiconductor layer can be obtained by suitable selecting the material of the coating section or by adjusting the film forming conditions.

Further, the dye-sensitized solar cell 10 can be manufactured in such a manner that the conductive metal layer 16 with the porous semiconductor layer 14, which is formed by applying the titania paste to the conductive metal layer 16 and sintering the titania paste, is sandwiched between the conductive substrate 18 made of, for example, a Ti foil, and the substrate 12 made of a plastic sheet. Thus, it is possible to mass-produce the dye-sensitized solar cell 10 at low cost by adopting a so-called roll to roll method.

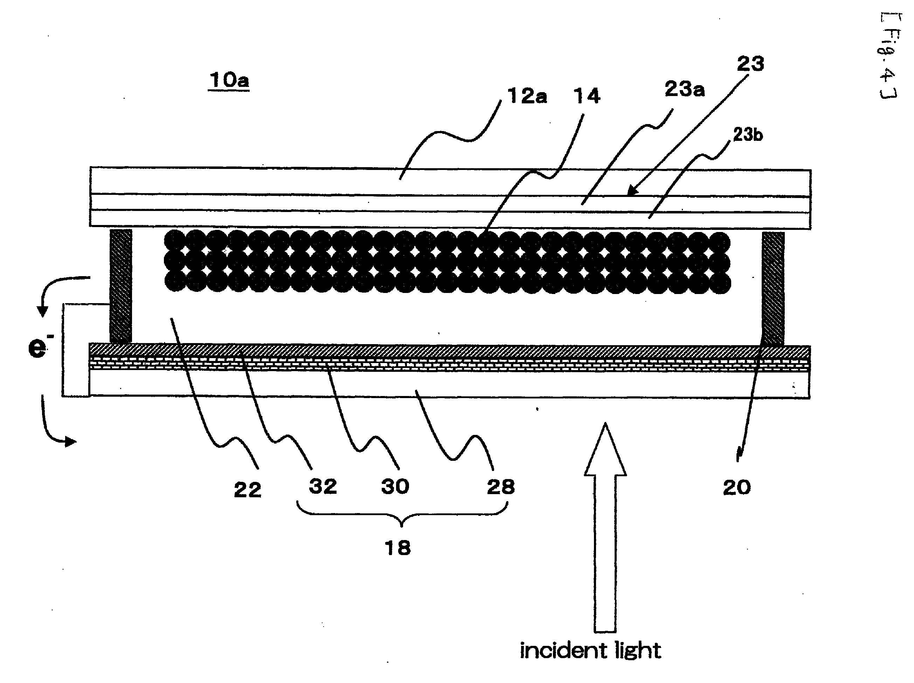

Next, a dye-sensitized solar cell according to a second example of the present embodiment will be described with reference to a schematic diagram shown in Figure 4.

A dye-sensitized solar cell 10a according to a second example of the present embodiment has roughly the same configuration as the configuration of the dye-sensitized solar cell 10, and hence the description of the overlapping components is omitted. Further, the effects of the dye-sensitized solar cell 10a are the same as the effects of the dye-sensitized solar cell 10 except those specifically described below, and hence the description of the overlapping effects is omitted.

The dye-sensitized solar cell 10a is greatly different from the dye-sensitized solar cell 10 in that incident light is introduced into the cell from the side of the conductive substrate 18 as the counter electrode so that the number of components can be reduced by integrally providing a substrate 12a and a conductive metal layer (hereinafter denoted by reference numeral 23) before the cell assembly.

In order to realize the above-described structure, a transparent substrate is used as the conductive substrate 18. Note that the substrate 12a may be a transparent substrate or an opaque substrate. The conductive metal layer 23 is a current collector provided on the surface of the substrate 12a, and is configured by a sheet-like conductive metal section 23a provided on the side in contact with the substrate 12a, and further by a sheet-like coating section 23b provided so as to cover the conductive metal section 23a.

The substrate 12a can be omitted as long as the conductive metal layer 23 has a certain level of rigidity. Further, when the substrate 12a is used, the mesh member can also be used as the conductive metal section 23a.

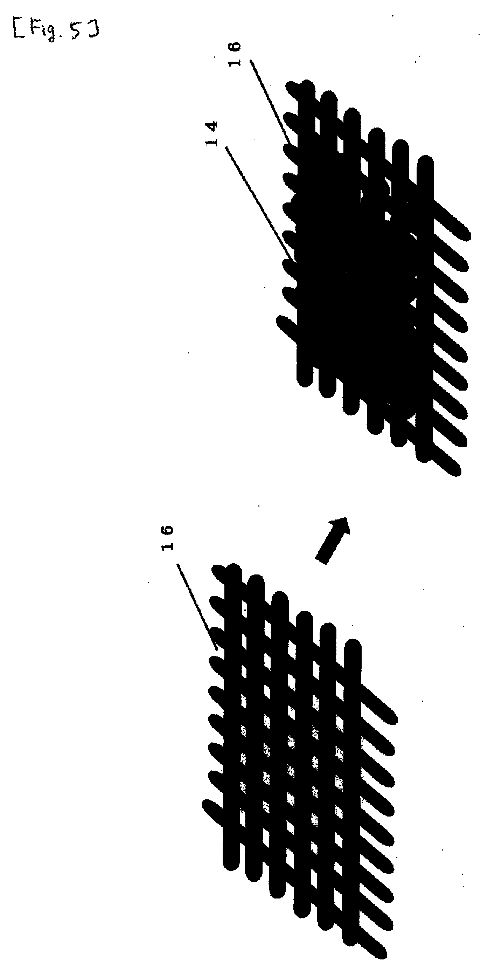

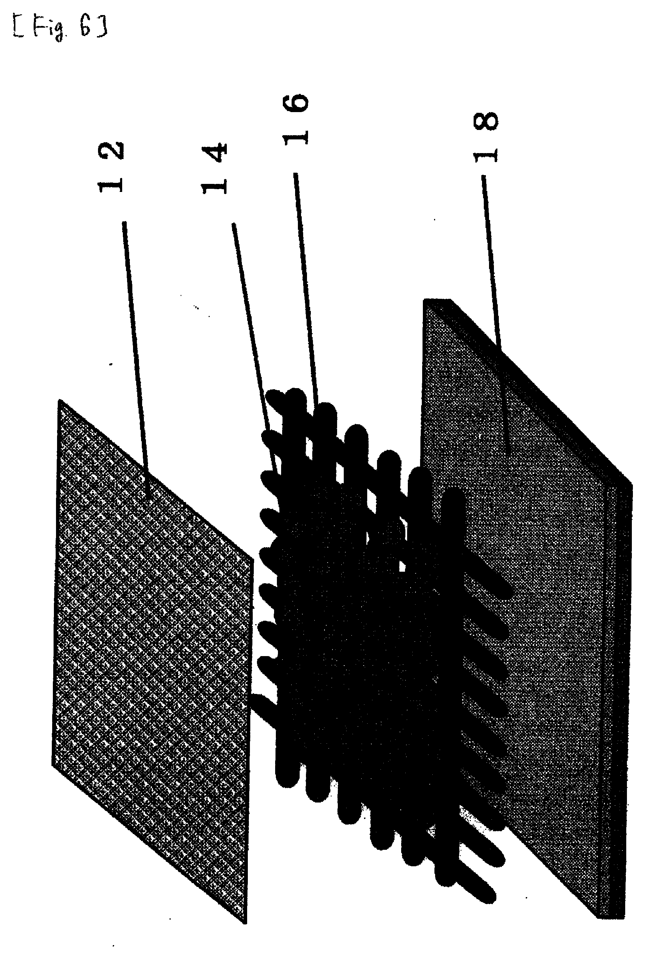

Next, a manufacturing method of the dye-sensitized solar cell according to the present embodiment, which is capable of suitably manufacturing each of the examples of the present embodiment, will be described with reference to schematic diagrams shown in Figure 5 and Figure 6.

The manufacturing method will be described by talking, as an example, the dye-sensitized solar cell 10.

The mesh member (wire net) shown in Figure 2 is used as the conductive metal section 17 of the conductive metal layer. Note that the following process is not changed also when the perforated sheet-like conductive metal layer shown in Figure 3 is used as the conductive metal layer. For convenience of description, before the description of the process of manufacturing the conductive metal layer, the process of manufacturing the dye-sensitized solar cell by using the manufactured conductive metal layer is first described. This process is not different from the process of manufacturing the conventional dye-sensitized solar cell.

As shown in Figure 5, the porous semiconductor layer 14 is formed on the conductive metal layer 16 by applying, for example, the titania paste on the manufactured conductive metal layer 16 and then by sintering the titania paste at a temperature of 450°C.

Then, the conductive metal layer 16 with the porous semiconductor layer 14 is immersed in a solution of a dye for 48 hours so as to make the porous semiconductor layer 14 adsorb the dye.

Subsequently, as shown in Figure 6, a cell is assembled by using spacers (not shown) so that the conductive metal layer 16 with the porous semiconductor layer 14 adsorbing the dye is sandwiched between the separately manufactured substrate 12 and the separately manufactured conductive substrate 18 that is the substrate provided with the transparent conductive film and the catalyst film. Then, the dye-sensitized solar cell is manufactured by injecting the electrolytic solution into the cell. Note that, in this case, when the cell is configured such that the porous plastic sheet with the electrolytic solution impregnated therein is arranged between the conductive substrate 18 and the conductive metal layer 16 with the porous semiconductor layer 14 adsorbing the dye, the process of injecting the electrolytic solution into the cell after completion of the cell can be omitted. Thus, this configuration is suitable for adopting the above-described roll to roll method.

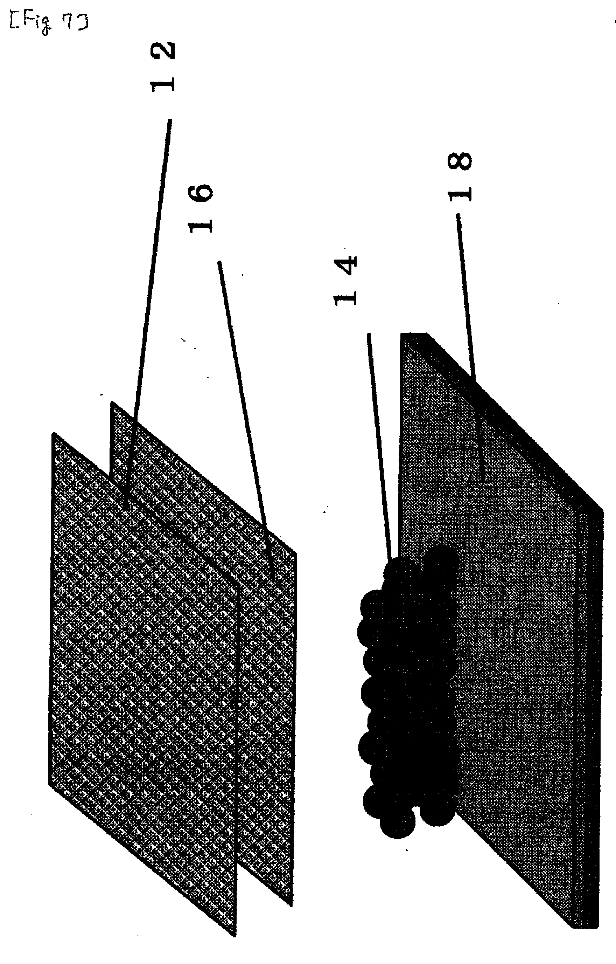

Note that when the dye-sensitized solar cell 10a is manufactured, the manufacturing method is the same as the above-described method, except that, as shown in Figure 7, the sheet-like conductive metal layer 16 is formed on the substrate 12 by using a thin-film forming method, so as to manufacture the substrate 12 with the conductive metal layer 16, and that the porous semiconductor layer 14 is then formed on the conductive metal layer 16 by applying, for example, the titania paste on the substrate 12 with the conductive metal layer 16 and then by sintering the titania paste at a temperature of 450°C. Here, in Figure 7, for convenience of illustration, the conductive metal layer 16 and the substrate 12 are illustrated to be separated from each other, but actually the conductive metal layer 16 is formed in close contact with the substrate 12 as described above.

Next, the manufacturing method of the conductive metal layer will be described.

In the case of the dye-sensitized solar cell 10, a film of a raw material metal of the coating section is formed by a thin-film forming technique while a small amount of a compound containing one or more kinds of elements selected from a group of O, N, S, P, B and C is introduced toward the conductive metal section, such as the mesh member. Thereby, the coating section having the graded composition structure of the degree of oxidization, in other words, the degree of thermal expansion coefficient, is formed on the conductive metal section. It is more preferred that the element to be introduced is O or N.

On the other hand, in the case of the dye-sensitized solar cell 10a, the sheet-like conductive film, which is the conductive metal section, is formed on the substrate, and then the sheet-like coating section is formed on the conductive film similarly to the above described method.

Further, as described above, the graded composition structure may be formed by using two or more kinds of materials having different thermal expansion coefficients, or the graded composition structure may also be formed in such a manner that two or more layers having different thermal expansion coefficients are formed by two or more film-forming stages that respectively use different film-forming methods using the same material.

For example, in the case where Ti is used as the raw material metal to form the film of the coating section, when the portion of the coating section on the side of the porous semiconductor layer 14 is formed into a structure having a high degree of oxidization and close to the structure of TiO₂, a thermal expansion coefficient close to the thermal expansion coefficient of 5×10⁻⁶/°C of the porous semiconductor layer 14 can be obtained, while when the portion of the coating section on the side of the conductive metal section 17 is formed into a structure having a low degree of oxidization and close to the structure of Ti, a thermal expansion coefficient close to the thermal expansion coefficient of 8.4×10⁻⁶/°C of the conductive metal section 17 can be obtained.

Note that a suitable method can be used, as required, to measure the value of thermal expansion coefficient and the degree of oxidation.

The degree of oxidization can be calculated from the ratios of the peak intensities of the metal and oxygen as reference materials with respect to the peak intensity of the sample, the peak intensities of which are obtained by using, for example, the Auger electron spectroscopy (scanning Auger electron spectroscopy analyzer ULVAC PHI-700).

The thermal expansion coefficient, for example, which corresponds to the degree of oxidization obtained by the measurement of the degree of oxidization, can be calculated from the values described in the Metal Hand Book 5th Edition (published by Maruzen), and the like.

The thin-film forming technique used to form the coating section is not particularly limited, but a sputtering method or a vacuum vapor deposition method is used.

At this time, the coating section having the graded composition structure can be formed by using only one of these methods. Preferably, the method for forming the coating section having the graded composition structure includes a stage for forming a sputtered layer on the surface of the conductive metal section by the sputtering method, and a stage for forming a vapor deposition layer on the surface of the sputtered layer by the vacuum vapor deposition method.

In the coating section, the aggregate of the metal fine particles of the outer layer formed by the vacuum vapor deposition method has a smaller size of the metal fine particles as compared with the aggregate of the metal fine particles of the inner layer formed by the sputtering method. This is also considered to contribute to the fact that the graded composition structure having a large composition change is suitably formed. Further, the film thickness of the vapor deposition layer is significantly increased during the subsequent sintering process. This is considered to indicate that the oxidization in the vapor deposition layer is sufficiently carried out during the sintering process, to contribute to the reduction of generation of a crack in the vapor deposition layer during the sintering process.

It is more preferred that, when an arc plasma vapor deposition method (plasma arc deposition method) or a vacuum arc vapor deposition method is used as the vacuum vapor deposition method, it is possible to obtain the coating section which is dense and excellent in flatness.

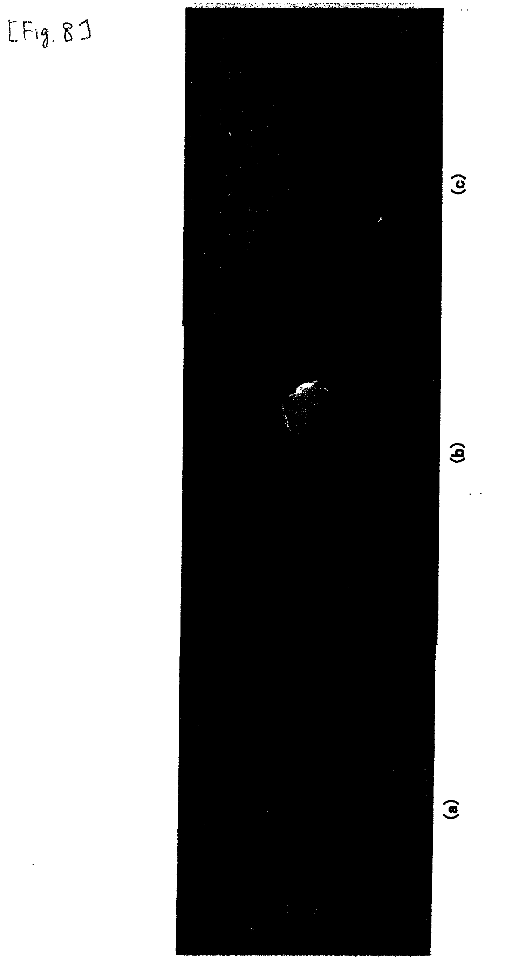

Figure 8 shows the results of SEM observation of the surface of the coating section obtained by the sintering at a temperature of 450°C for 30 minutes. In Figure 8, Figure 8(a) shows the result of observation of the layer formed by the conventional application method, Figure 8(b) shows the result of observation of the layer formed by the sputtering method of the present embodiment, and Figure 8(c) shows the result of observation of the layer formed by the arc plasma vapor deposition method of the present embodiment. Note that as examples of the flatness, the following results are obtained: Figure 8(a) shows that the surface roughness Ra of the layer formed by the conventional application method is 5.28 nm, Figure 8(b) shows that the surface roughness Ra of the layer formed by the sputtering method of the present embodiment is 1.96 nm, and Figure 8(c) shows that the surface roughness Ra of the layer formed by the arc plasma vapor deposition method of the present embodiment is 0.55 nm.

Further, although not shown, according to the SEM observation, when the porous semiconductor layer was formed on the stainless steel mesh coated with no coating section, it was clearly observed that a crack was generated on the stainless steel mesh. Further, when the porous semiconductor layer was formed on the stainless steel mesh coated with the coating section formed by the conventional application method, a crack was observed in the coating section or on the stainless steel mesh, and an unevenness of the porous semiconductor layer was observed. Further, when the porous semiconductor layer was formed on the stainless steel mesh coated with the coating section laminated and formed by the sputtering method and the arc plasma vapor deposition method of the present embodiment, it was observed that no crack was generated and that the porous semiconductor layer was uniformly formed on the stainless steel mesh.

Further, although data are omitted, when the contact angle was measured, a larger value was obtained for the stainless steel mesh coated with the coating section laminated and formed by the sputtering method and the arc plasma vapor deposition method of the present embodiment, as compared with the stainless steel mesh coated with the coating section formed by the conventional application method.

### Examples

The present invention will be further described by means of examples and comparison examples. Note that the present invention is not limited to the examples described below.

### (Used stainless steel mesh)

Stainless steel mesh #500 (wire diameter: 0.025 mm, mesh opening (opening size, opening space): 0.026 mm, space ratio: 25.8%, thickness: 55 µm, and material: SUS316) made by NBC Corp. was used.

### (Example 1)

On both surfaces of the stainless steel mesh having a size of 40 mmx50 mm, a sputtered film having a film thickness of 200 nm was formed by using Ti as a raw material metal and by performing processing by the sputtering method at the output of 250 W for 50 minutes. At this time, the pressure in the chamber of the film-forming apparatus was maintained at 4.0×10⁻⁴ Pa by introducing and circulating a small amount of oxygen gas through the chamber having the initial inner pressure of 2.0×10⁻⁴ Pa.

After the stainless steel mesh with the sputtered film formed thereon was cut to a size of 20 mm×25 mm, a TriO₂ paste for screen printing (Ti-Nanoxide D/SP) made by Solaronix SA Corp. was applied on the sputtered film by the squeegee method using a metal mask (20 mm×5 mm). Thereafter, the TiO₂ paste was sintered at a temperature of 450°C in an electric furnace for 30 minutes. After being cooled, the sintered TiO₂ paste of the stainless steel mesh was immersed in a dye (N719) solution for 48 hours and was then sufficiently rinsed with a mixed solution of acetonitrile and t-butyl alcohol (1:1 (v/v)). Thereafter, the stainless steel mesh with the films formed thereon was cut to a size of 25 mm×5 mm, so that a conductive metal layer having a porous semiconductor layer adsorbing the dye was obtained.

On the other hand, a polyethylene porous film (film thickness: 40 µm, space ratio: 80%) made by Nippon Sheet Glass Corp. was cut to a size of 15 mm×10 mm and was then immersed in an organic solvent-based electrolytic solution (Lil 500mM, l₂ 50mM, t-Bupy 580mM, MeEtlmN(CN)₂ 600mM, in Acetonitorile), so that a porous film was manufactured. Also, a platinum-spattered Ti counter electrode was manufactured (at the output of the platinum sputtering: 200 W/50 min, to obtain the thickness of Ti plate: 3 mm).

The porous film and the platinum-sputtered counter electrode were laminated in this order on the side of the conductive metal layer, the side being opposite to the side on which the porous semiconductor layer is provided. The obtained laminate was sandwiched between two micro slide glass plates cut to a size of 26 mm×10 mm (S1127, thickness: 1.2 mm) made by MATSHNAMI Corp. and sealed with epoxy resin, so that a solar cell was obtained.

The evaluation of performance of the obtained solar cell was carried out by using a solar simulator (dye-sensitized type spectral sensitivity measuring device KHP-1 type) made by BUNKOUKEIKI Corp.

The results of the performance evaluation are shown in Table 1. In Table 1, "efficiency" represents the conversion efficiency, "FF" represents the fill factor, "Voc" represents the light open-circuit voltage, and "Jsc" represents the light short-circuit current. Note that the results of the performance evaluation of the other examples and the comparison examples as will be described below are also shown in Table 1.

### (Example 2)

A solar cell was manufactured by the same method as in Example 1 except that, in place of the spattered film, the stainless steel mesh was coated with an arc plasma film formed by the arc plasma vapor deposition method, and then the evaluation of performance of the solar cell was carried out by the same method as in Example 1.

An arc plasma film having a film thickness of 100 mm was formed by 2000 shots in the arc plasma vapor deposition method while the pressure in the chamber of the film-forming apparatus was maintained at 4.0×10⁻⁴ Pa by introducing a small amount of oxygen gas into the chamber.

### (Example 3)

A solar cell was manufactured by the same method as in Example 1 except that the stainless steel mesh was coated with the spattered film and further coated with the arc plasma film on the conditions in Examples 1 and 2, and then the evaluation of performance of the solar cell was carried out by the same method as in Example 1.

### (Example 4)

A solar cell was manufactured by the same method as in Example 1 except that, in place of the stainless steel mesh, a porous Ti foil having a film thickness of 20 µm and having holes of a hole diameter of 75 µm formed at a hole pitch of 150 µm by using an NC drill was used and coated with an arc plasma film formed by the arc plasma vapor deposition method, and then the evaluation of performance of the solar cell was carried out by the same method as in Example 1.

### (Example 5)

On each surface of the stainless steel mesh having a size of 40 mm×50 mm, a sputtered film having a film thickness of 300 nm was formed by using W as the raw material metal and by performing processing by the sputtering method at the output of 200 W for 60 minutes. At this time, the pressure in the chamber of the film-forming apparatus was maintained at 4.0×10⁻⁴ Pa by introducing and circulating a small amount of oxygen gas through the chamber having the initial inner pressure of 2.5×10⁻⁴ Pa.

After the stainless steel mesh with sputtered film formed thereon was cut to a size of 20 mm×25 mm, a TiO₂ paste (Ti-Nanoxide D/SP) for screen printing made by Solaronix SA Corp. was applied onto the sputtered film by a squeegee method using a metal mask (20 mm×5mm). Then, the applied TiO₂ paste was sintered in an electric furnace at a temperature of 450°C for 60 minutes. After being cooled, the sintered TiO₂ paste of the stainless steel mesh was immersed in a dye (black dye) solution for 24 hours and was then sufficiently rinsed with a mixed solution of acetonitrile and t-butyl alcohol (1:0.9 (v/V)). Thereafter, the stainless steel mesh with the films formed thereon was cut to a size of 25 mm×5 mm, so that a conductive metal layer having a porous semiconductor layer adsorbing the dye was obtained.

On the other hand, a polyethylene porous film (film thickness: 40 µm, space ratio: 80%) made by Nippon Sheet Glass Co. was cut to a size of 15 mm×10 mm and was then immersed in an organic solvent-based electrolytic solution (Lil 500mM, l₂ 50mM, t-Bupy 580mM, MeEtlmN(CN)₂ 600mM, in Acetonitorile), so that a porous film was made. Also, a platinum-spattered Ti counter electrode was manufactured (at the output of the platinum sputtering: 250 W/50 min, to obtain the thickness of Ti plate: 4 mm).

The porous film and the platinum-sputtered counter electrode were laminated in this order on the side of the conductive metal layer, the side being opposite to the side on which the porous semiconductor layer was formed. The obtained laminate was sandwiched between two micro slide glass plates cut to a size of 26 mm×10 mm (S1127, thickness: 1.2 mm) made by MATSHNAMI Corp. and sealed with epoxy resin, so that a solar cell was obtained.

The evaluation of performance of the obtained solar cell was carried out by the same method as in Example 1.

### (Comparison example 1)

A solar cell was manufactured by the same method as in Example 1 except that the stainless steel mesh coated with no coating film was used, and the evaluation of performance of the obtained solar cell was carried out by the same method as in Example 1.

### (Comparison example 2)

A solar cell was manufactured by the same method as in Example 1 except that a TiO₂ film having a film thickness 200 nm was formed on the stainless steel mesh by the application method, and the evaluation of performance of the obtained solar cell was carried out by the same method as in Example 1.

### (Comparison example 3)

A solar cell was manufacture by the same method as in Example 4 except that a porous Ti foil coated with no coating film was used, and the evaluation of performance of the obtained solar cell was carried out by the same method as in Example 4.

**[Table 1]**

| | **Efficiency (%)** | **FF** | **V_{oc} (V)** | **J_{sc} (mA/cm²)** |
|---|---|---|---|---|
| **Example 1** | **3.85** | **0.59** | **0.75** | **8.75** |
| **Example 2** | **3.42** | **0.52** | **0.67** | **9.82** |
| **Example 3** | **4.68** | **0.65** | **0.74** | **9.8** |
| **comparison example 1** | **2.21** | **0.51** | **0.65** | **6.74** |
| **Comparison example 2** | **2.87** | **0.52** | **0.66** | **8.43** |
| **Example 4** | **4.60** | **0.70** | **0.82** | **8.1** |
| **Comparison example 3** | **3.60** | **0.63** | **0.78** | **7.4** |
| **Example 5** | **4.50** | **0.65** | **0.75** | **9.25** |

### Reference Signs List

- 10: Dye-sensitized solar cell
- 12, 28: Substrate
- 14: Porous semiconductor layer
- 16, 16a, 23: Conductive metal layer
- 17, 17a, 23a: Conductive metal section
- 18: Conductive substrate
- 19, 23b: Coating section
- 19a: Inner layer
- 19b: Outer layer
- 21: Internal spacer
- 20: Spacer
- 22: Electrolyte
- 23a: Conductive metal section
- 26: External electrode
- 30: Transparent conductive film
- 32: Catalyst film

## Claims

1. A dye-sensitized solar cell including a substrate, a conductive substrate serving as a cathode electrode, a porous semiconductor layer adsorbing a dye and arranged between the substrate and the conductive substrate so as to be close to or in contact with the substrate, and a conductive metal layer arranged in contact with the porous semiconductor layer so as to serve as an anode electrode, at least one of the substrate and the conductive substrate being a transparent substrate, and an electrolyte being enclosed between the substrate and the conductive substrate,
wherein the conductive metal layer is configured by a conductive metal section and a coating section formed at least on the side of the conductive metal section, the side being in contact with the porous semiconductor layer, and
wherein the coating section comprises a graded composition structure in which the thermal expansion coefficient of the coating section is reduced from the side of the conductive metal section toward the side of the porous semiconductor layer.

2. The dye-sensitized solar cell according to claim 1, wherein the coating section comprises a graded composition structure in which the degree of oxidation of the coating section is increased from the side of the conductive metal section toward the porous semiconductor layer.

3. The dye-sensitized solar cell according to claim 2, wherein the coating section is formed of an oxide of one or more kinds of corrosion-resistant metal materials selected from a group of Ti, W, Ni, Pt and Au.

4. The dye-sensitized solar cell according to one of claim 2 and claim 3, wherein the conductive metal layer is a current collector arranged on the side of the porous semiconductor layer, the side being opposite to the side on which the substrate is provided, wherein the conductive metal section has numerous holes formed therein for allowing the electrolyte to freely flow through the porous semiconductor layer and is electrically connected to an external electrode, and wherein the substrate is a transparent substrate.

5. The dye-sensitized solar cell according to claim 4, wherein the conductive metal section of the conductive metal layer is formed of a mesh member.

6. The dye-sensitized solar cell according to one of claim 2 and claim 3, wherein the conductive metal layer is a current collector provided on the surface of the substrate, wherein the conductive metal section is provided on the side in contact with the substrate, and the coating section is provided to cover the conductive metal section, and wherein the conductive substrate is a transparent substrate.

7. The dye-sensitized solar cell according to claim 1, wherein the coating section has a laminated structure which is formed of two or more kinds of different materials so that the thermal expansion coefficient of the coating section is reduced from the side of the conductive metal section toward the side of the porous semiconductor layer.

8. A manufacturing method of the dye-sensitized solar cell according to one of claim 2 to claim 6,
wherein in the process of forming the coating section on the conductive metal section formed beforehand, the graded composition structure is formed by forming a film of a raw material metal of a conductive metal coating by a thin-film forming technique while introducing a small amount of a compound containing one or more kinds of elements selected from a group of O, N, S, P, B and C.

9. A manufacturing method of the dye-sensitized solar cell according to one of claim 2 to claim 6,
wherein in the process of forming the coating section on the conductive metal section formed beforehand, the graded composition structure is formed by including a stage of forming a sputtered layer by a sputtering method, and a stage of forming a vapor deposition layer on the surface of the sputtered layer by a vacuum vapor deposition method.

10. The manufacturing method of the dye-sensitized solar cell, according to claim 9, wherein the vacuum vapor deposition method is one of an arc plasma vapor deposition method and a vacuum arc vapor deposition method.
